(19) Europäisches Patentamt
European Patent Office
Office européen des brevets

(11) EP 2 452 989 A1

(12) EUROPEAN PATENT APPLICATION
published in accordance with Art. 153(4) EPC

(43) Date of publication:
**16.05.2012 Bulletin 2012/20**

(21) Application number: **10797021.2**

(22) Date of filing: **23.06.2010**

(51) Int Cl.:
***C09J 7/00*** *(2006.01)* ***C09J 11/06*** *(2006.01)*
***C09J 133/20*** *(2006.01)* ***C09J 161/06*** *(2006.01)*
***C09J 201/00*** *(2006.01)* ***H05K 1/03*** *(2006.01)*

(86) International application number:
**PCT/JP2010/060670**

(87) International publication number:
**WO 2011/004710 (13.01.2011 Gazette 2011/02)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **09.07.2009 JP 2009162523**

(71) Applicant: **Nitto Denko Corporation**
**Ibaraki-shi**
**Osaka 567-8680 (JP)**

(72) Inventors:
- **KUWAHARA, Rie**
**Ibaraki-shi**
**Osaka 567-8680 (JP)**
- **OURA, Masahiro**
**Ibaraki-shi**
**Osaka 567-8680 (JP)**
- **NONAKA, Takahiro**
**Ibaraki-shi**
**Osaka 567-8680 (JP)**
- **DAIGAKU, Noritsugu**
**Ibaraki-shi**
**Osaka 567-8680 (JP)**

(74) Representative: **Grünecker, Kinkeldey, Stockmair & Schwanhäusser**
**Leopoldstrasse 4**
**80802 München (DE)**

# (54) HEAT-CURABLE ADHESIVE TAPE OR SHEET AND FLEXIBLE PRINTED CIRCUIT BOARD

(57) The present invention provides a thermosetting adhesive tape or sheet having a thermosetting adhesive layer, which can be stored stably at room temperature, and, when thermally cured, can exert excellent adhesiveness and high thermal stability after exposure to heat and moist, because the resin in the adhesive rapidly reacts upon curing. The thermosetting adhesive tape or sheet according to the present invention includes a thermosetting adhesive layer which has a gel fraction of less than 70%, a difference in gel fraction between before and after storage at 40°C for 7 days [(gel fraction after storage at 40°C for 7 days)-(gel fraction before storage at 40°C for 7 days)] of 15% or less, and a gel fraction after curing at 150°C for 1 hour of 90% or more.

EP 2 452 989 A1

## Description

### Technical Field

The present invention relates to thermosetting adhesive tapes or sheets having thermosetting adhesive layers, and to flexible printed circuit boards. More specifically, it relates to thermosetting adhesive tapes or sheets which are advantageously adopted typically to flexible printed circuit boards and also relates to flexible printed circuit boards having the thermosetting adhesive tapes or sheets.

### Background Art

Flexible printed circuit boards (hereinafter also briefly referred to as "FPC(s)") are widely used in electronic devices. In such FPCs, adhesives are used typically in (1) a process of fabricating the FPC by laminating and bonding an electroconductive metallic foil, such as copper foil or aluminum foil, on a heat-resistant substrate such as a polyimide substrate or a polyamide substrate, and in (2) a process of bonding the FPC to a reinforcing sheet such as aluminum sheet, stainless steel sheet, or polyimide sheet.
Exemplary known adhesives for use in bonding of FPCs include an adhesive composed of an elastomer and a resol type phenolic resin crosslinking agent (see Patent Literature 1); and an adhesive composed of an elastomer, an epoxy resin, and an epoxy-resin curing agent (see Patent Literature 2).

### Citation List

#### Patent Literature

Patent Literature 1: Japanese Unexamined Patent Application Publication (JP-A) No. 2005-239830
Patent Literature 2: Japanese Unexamined Patent Application Publication (JP-A) No. 2002-275444

### Summary of Invention

#### Technical Problem

These adhesives show adhesive strengths by curing resins in the adhesives through heating at 150°C or higher. However, the adhesives may suffer from blister and/or separation when the adhesives after bonding with adherends (such as FPCs) are passed through a process performed at high temperatures, such as a reflow process, and whereby water and other components contained in the adhesives or adherends evaporate. These phenomena are frequently caused by insufficient curing of the adhesives. For performing sufficient curing, the curing temperature should be elevated and/or the curing time (duration) should be elongated to allow the adhesives to have satisfactorily high gel fractions.
In addition, the adhesives lose their adhesiveness during storage, because the resins in the adhesives have reactivity and thereby undergo curing reactions during storage. The adhesives should therefore be stored through chilled storage or frozen storage and thereby have poor handleability.
Accordingly, an object of the present invention is to provide a thermosetting adhesive tape or sheet having a thermosetting adhesive layer which does not suffer from aging (change with time) during storage, which can be rapidly and sufficiently cured upon curing, and, after curing, which can exert excellent adhesiveness and high thermal stability after exposure to heat and moist (thermal stability after storage under hot and humid conditions).

#### Solution to Problem

After intensive investigations, the present inventors have found that, in a thermosetting adhesive tape or sheet having a specific thermosetting adhesive layer, the thermosetting adhesive layer is satisfactorily stable during storage, is rapidly and sufficiently cured upon curing, and, after curing, exerts excellent adhesiveness and high thermal stability after exposure to heat and moist. The present invention has been made based on these findings.
Specifically, the present invention provides, in an embodiment, a thermosetting adhesive tape or sheet comprising a thermosetting adhesive layer, in which the thermosetting adhesive layer has a gel fraction of less than 70%, a difference in gel fraction between before and after storage at 40°C for 7 days [(gel fraction after storage at 40°C for 7 days)-(gel fraction before storage at 40°C for 7 days)] of 15% or less, and a gel fraction after curing at 150°C for 1 hour of 90% or more.

The thermosetting adhesive layer may be formed from a thermosetting adhesive composition containing an acrylic polymer (X) as a main component.
The acrylic polymer (X) preferably contains a ($C_2$-$C_{14}$)-alkyl (meth)acrylate as an essential monomer component.
The acrylic polymer (X) may contain the ($C_2$-$C_{14}$) -alkyl (meth)acrylate (a), a cyano group-containing monomer (b), and a carboxyl group-containing monomer (c) as monomer components.
The thermosetting adhesive layer may be formed from a thermosetting adhesive composition containing the acrylic polymer (X) and an etherified phenolic resin (Y).
The thermosetting adhesive composition preferably further contains an acid (Z).
The present invention further provides, in another embodiment, a flexible printed circuit board including the thermosetting adhesive tape or sheet.
In yet another embodiment, the present invention provides a thermally-cured thermosetting adhesive tape or sheet as a thermally-cured product of the thermosetting adhesive tape or sheet.
In still another embodiment, the present invention provides a flexible printed circuit board including the thermally-cured thermosetting adhesive tape or sheet.
The thermosetting adhesive tape or sheet may be adopted as a thermosetting adhesive tape for a flexible printed circuit board.

## Advantageous Effects of Invention

According to the present invention, there is provided a thermosetting adhesive tape or sheet which is satisfactorily stable during storage, can be rapidly and sufficiently cured upon curing, and, after curing, shows excellent adhesiveness and high thermal stability after exposure to heat and moist.

## Brief Description of Drawings

FIG. 1 is a graph showing an exemplary temperature profile as a heating treatment condition in a reflow process employed in a method for evaluating the thermal stability after exposure to heat and moist.

## Description of Embodiments

The present invention will be illustrated in detail below with reference to some embodiments thereof.
The thermosetting adhesive tape or sheet according to the present invention is a thermosetting adhesive tape or sheet having a specific thermosetting adhesive layer (hereinafter also referred to as a "thermosetting adhesive layer according to the present invention"). This thermosetting adhesive layer has a gel fraction of less than 70%, a difference in gel fraction between before and after storage at 40°C for 7 days [(gel fraction after storage at 40°C for 7 days)-(gel fraction before storage at 40°C for 7 days)] of 15% or less, and a gel fraction after curing at 150°C for 1 hour of 90% or more.
The thermosetting adhesive tape or sheet according to the present invention has only to include the thermosetting adhesive layer and may have a substrate or not, as described below. The thermosetting adhesive tape or sheet may further include, for example, a thermosetting adhesive layer other than the thermosetting adhesive layer according to the present invention.

## Thermosetting Adhesive Layer According to The Present Invention

The gel fraction of the thermosetting adhesive layer according to the present invention is less than 70% (for example, 0% or more and less than 70%), preferably less than 60%, and more preferably less than 50%. The gel fraction can be determined as a content of components insoluble in methyl ethyl ketone (insoluble content). Specifically, the gel fraction is determined as a weight fraction (unit: percent by weight) of insoluble content after immersion in methyl ethyl ketone at room temperature (23°C) for 7 days, relative to the sample before immersion. The thermosetting adhesive layer according to the present invention, if having a gel fraction of 70% or more, may show inferior flexibility.
Specifically, the gel fraction (solvent insoluble content) herein is a value calculated typically according to the following "method for measuring gel fraction".

## Method for Measuring Gel Fraction

A tape piece (sheet piece) having a size of 5 cm by 5 cm is cut from a sample thermosetting adhesive tape or sheet. When the tape or sheet is a substrate-less (base-less) thermosetting adhesive tape or sheet and the tape piece includes a release liner, the release liner is removed to give a thermosetting adhesive layer for measuring gel fraction.

When the tape or sheet is a substrate-supported thermosetting adhesive tape or sheet, the thermosetting adhesive layer is scraped off from the tape piece (sheet piece) to give a thermosetting adhesive layer for measuring gel fraction. The thermosetting adhesive layer for measuring gel fraction is covered by a porous tetrafluoroethylene sheet (supplied by Nitto Denko Corporation under the trade name "NTF 1122") having an average pore size of 0.2 μm, tied with a kite string, the weight of the resulting article is measured, and this weight is defined as a "weight before immersion". The "weight before immersion" is the total weight of the thermosetting adhesive layer, the tetrafluoroethylene sheet, and the kite string. Independently, the total weight of the tetrafluoroethylene sheet and the kite string is measured as a tare weight.

Next, the thermosetting adhesive layer covered by the tetrafluoroethylene sheet and tied with the kite string (the whole article is hereinafter also referred to as a "sampled") is placed in a 50-ml vessel filled with methyl ethyl ketone, and left stand at room temperature (23°C) for one week (7 days). The sample after immersion in methyl ethyl ketone is retrieved from the vessel, transferred into an aluminum cup, dried in a drier at 130°C for 2 hours to remove methyl ethyl ketone, and the weight of the resulting sample is measured as a weight after immersion.

A gel fraction is calculated according to the following formula:

$$\text{Gel fraction (percent by weight)} = (A-B)/(C-B) \times 100 \quad (1)$$

wherein "A" represents the weight after immersion; "B" represents the tare weight; and "C'" represents the weight before immersion.

The difference in gel fraction between before and after storage at 40°C for 7 days of the thermosetting adhesive layer according to the present invention is 15% or less, preferably 10% or less, more preferably 5% or less, still more preferably 3% or less, and most preferably 0%. The difference in gel fraction between before and after storage at 40°C for 7 days can be calculated according to the following formula:

$$\text{Difference in gel fraction (\%)} = [(\text{Gel fraction after storage at 40°C for 7 days (percent by weight)}) - (\text{Gel fraction before storage at 40°C for 7 days (percent by weight)})]$$

The storage stability test at 40°C for 7 days is an accelerating test, which result gives an indication of the storage stability of a thermosetting adhesive tape or sheet (thermosetting adhesive layer) at room temperature (23°C) for a long period of time (for example, 6 months). Specifically, with an increasing difference in gel fraction in the storage stability test at 40°C for 7 days, the thermosetting adhesive layer becomes more liable to undergo a curing reaction even at room temperature (23°C), is thereby liable to show inferior storage stability, and the resulting thermosetting adhesive tape or sheet may become difficult to handle. In contrast, with a decreasing difference in gel fraction, the thermosetting adhesive layer becomes resistant to a curing reaction at room temperature and thereby tends to have satisfactory long-term storage stability. Accordingly, if the thermosetting adhesive layer has a difference in gel fraction exceeding 15%, the thermosetting adhesive tape or sheet suffers from a reaction of the component thermosetting resin even at room temperature (23°C), thereby fails to exert satisfactory adhesive strength upon bonding, and shows inferior long-term storage stability. Generally, a thermosetting adhesive layer, when having a difference in gel fraction between before and after storage at 40°C for 7 days of 15% or less, can give a thermosetting adhesive tape or sheet which excels in long-term storage stability and can be stored at room temperature for at least 6 months.

Specifically, the difference in gel fraction between before and after storage at 40°C for 7 days is determined, for example, by the following "method for measuring difference in gel fraction".

Method for Measuring Difference in Gel Fraction

A sample thermosetting adhesive tape or sheet before and after storage at 40°C for 7 days is used in the measurement. Hereinafter a thermosetting adhesive layer sampled from the thermosetting adhesive tape or sheet before storage is also referred to as an "initial thermosetting adhesive layer"; and a thermosetting adhesive layer sampled from the thermosetting adhesive tape or sheet after storage at 40°C for 7 days is also referred to as a "thermosetting adhesive layer after heating".

The gel fraction of the initial thermosetting adhesive layer and the gel fraction of the thermosetting adhesive layer after heating (after storage at 40°C for 7 days) are measured according to the "method for measuring gel fraction". Next, the difference in gel fraction between before and after storage (before and after heating) (difference in gel fraction) is determined from the gel fraction (percent by weight) of the initial thermosetting adhesive layer and the gel fraction (percent by weight) of the thermosetting adhesive layer after heating, according to the following formula:

$$\text{Difference in gel fraction (\%)} = E-D \qquad (2)$$

wherein D represents the gel fraction (percent by weight) of the initial thermosetting adhesive layer; and E represents the gel fraction (percent by weight) of the thermosetting adhesive layer after heating.

The gel fraction of the thermosetting adhesive layer according to the present invention after curing at 150°C for 1 hour is 90% or more, preferably 92% or more, and more preferably 96% or more. The upper limit of gel fraction of the thermosetting adhesive layer according to the present invention after curing at 150°C for 1 hour is not critical and may for example be 100%. The thermosetting adhesive layer, if having a gel fraction after curing at 150°C for 1 hour is less than 90%, may not undergo a sufficiently proceeding curing reaction during such curing at 150°C for 1 hour, and the resulting cured thermosetting adhesive layer may show insufficient adhesiveness and/or insufficient thermal stability after exposure to heat and moist, or the curing should be performed at a further higher curing temperature and/or should be performed for a further longer curing time to allow the thermosetting adhesive layer to bond satisfactorily, resulting in increased cost. The thermosetting adhesive layer according to the present invention, as having a gel fraction after curing at 150°C for 1 hour of 90% or more, can be cured rapidly and sufficiently and thereby gives a cured product that excels in adhesiveness and thermal stability after exposure to heat and moist.

Specifically, the gel fraction of the cured thermosetting adhesive layer at 150°C for 1 hour can be, for example, measured according to the following "method for measuring gel fraction after curing".

Method for Measuring Gel Fraction After Curing

In this method, a sample thermosetting adhesive tape or sheet according to the present invention after undergoing curing through heating at 150°C for 1 hour is used. Hereinafter a thermosetting adhesive layer sampled from the thermosetting adhesive sheet after undergoing the curing at 150°C for 1 hour is also referred to as a "cured thermosetting adhesive layer".

In the same manner as in the "method for measuring gel fraction", a cured thermosetting adhesive layer is sampled, covered by a porous tetrafluoroethylene sheet (supplied by Nitto Denko Corporation under the trade name "NTF 1122") having an average pore size of 0.2 μm, tied with a kite string, the weight of the resulting article is measured, and this weight is defined as a "weight before immersion". The "weight before immersion" is the total weight of the cured thermosetting adhesive layer, the tetrafluoroethylene sheet, and the kite string. Independently, the total weight of the tetrafluoroethylene sheet and the kite string is measured as a tare weight.

Next, the cured thermosetting adhesive layer covered by the tetrafluoroethylene sheet and tied with the kite string (sample) is placed in a 50-ml vessel filled with methyl ethyl ketone, and left stand at room temperature (23°C) for one week (7 days). The sample after immersion in methyl ethyl ketone is retrieved from the vessel, transferred into an aluminum cup, dried in a drier at 130°C for 2 hours to remove methyl ethyl ketone, and the weight of the resulting sample is measured as a weight after immersion.

A gel fraction is calculated according to the following formula:

$$\text{Gel fraction (percent by weight)} = (F-G)/(H-G) \times 100 \qquad (3)$$

wherein "F" represents the weight after immersion; "G" represents the tare weight; and "H" represents the weight before immersion.

The thermosetting adhesive layer according to the present invention, as having a gel fraction and a difference in gel fraction within the above-specified ranges, is satisfactorily stable during storage at room temperature. When heated, the thermosetting adhesive layer undergoes a rapidly and sufficiently proceeding curing reaction to have an increased bond strength (adhesive strength) and can be bonded to an adherend firmly with excellent thermal stability after exposure to heat and moist.

## Thermosetting Adhesive Composition

The thermosetting adhesive layer according to the present invention is not limited, as long as having a gel fraction of less than 70%, a difference in gel fraction between before and after storage at 40°C for 7 days of 15% or less, and a gel fraction after curing at 150°C for 1 hour of 90% or more. The thermosetting adhesive layer is preferably a thermosetting adhesive layer formed from a thermosetting adhesive composition containing an acrylic polymer (X) as a main component, and is more preferably a thermosetting adhesive layer formed from a thermosetting adhesive composition containing the acrylic polymer (X) and an etherified phenolic resin (Y) as essential constituents. The thermosetting adhesive composition may further contain an acid (Z) in addition to the acrylic polymer (X) and the etherified phenolic resin (Y).
The content of the acrylic polymer (X) in the thermosetting adhesive composition (100 percent by weight) is preferably 70 to 99 percent by weight, more preferably 80 to 99 percent by weight, and still more preferably 90 to 99 percent by weight.

## Acrylic Polymer (X)

The acrylic polymer (X) is not limited, as long as being composed of (formed from) an acrylic monomer as an essential monomer component. The acrylic polymer (X) is preferably an acrylic polymer composed of (a) an alkyl (meth) acrylate whose alkyl moiety being a linear or branched-chain alkyl group having 2 to 14 carbon atoms (hereinafter also referred to as "($C_2$-$C_{14}$)-alkyl (meth)acrylate") as an essential monomer component, and is more preferably an acrylic polymer composed of monomer components containing a ($C_2$-$C_{14}$)-alkyl (meth)acrylate (a), a cyano group-containing monomer (b), and a carboxyl group-containing monomer (c). Among such acrylic polymers, still more preferred are acrylic polymers composed of monomer components including 39.5 to 75 percent by weight of the ($c_2$-$C_{14}$)-alkyl (meth) acrylate (a), 24 to 60 percent by weight of the cyano group-containing monomer (b), and 0.5 to 10 percent by weight of the carboxyl group-containing monomer (c) based on the total amount of monomer components (100 percent by weight). The monomer components may further contain one or more other monomer components than those mentioned above.
Among them, preferred as the acrylic polymer (X) is an acrylic polymer which develops rubber elasticity (elastomeric properties).
The ($C_2$-$C_{14}$)-alkyl (meth)acrylate (a) is not especially limited, as long as being an alkyl (meth)acrylate [alkyl acrylate and/or alkyl methacrylate] whose alkyl moiety being a linear or branched-chain alkyl group having 2 to 14 carbon atoms. Examples thereof include ethyl (meth)acrylates, propyl (meth)acrylates, isopropyl (meth)acrylates, n-butyl (meth) acrylates, isobutyl (meth)acrylates, s-butyl (meth)acrylates, t-butyl (meth)acrylates, pentyl (meth)acrylates, isopentyl (meth)acrylates, hexyl (meth)acrylates, heptyl (moth)acrylates, octyl (meth)acrylates, 2-ethylhexyl (meth)acrylates, isooctyl (meth)acrylates, nonyl (meth)acrylates, isononyl (meth)acrylates, decyl (meth)acrylates, isodecyl (meth)acrylates, undecyl (meth)acrylates, dodecyl (meth)acrylates, tridecyl (meth)acrylates, and tetradecyl (meth)acrylates. Among them, alkyl (meth)acrylates whose alkyl moiety having 4 to 12 carbon atoms are preferred, of which n-butyl acrylate is more preferred.
Each of different ($c_2$-$C_{14}$)-alkyl (meth)acrylates (a) may be used alone or in combination.
In the present invention, the ($C_2$-$C_{14}$)-alkyl (meth)acrylate (a) is preferably used as an essential monomer component for constituting the acrylic polymer (X). The amount of the ($C_2$-$C_{14}$)-alkyl (meth)acrylate (a) is preferably 39.5 to 75 percent by weight, more preferably 44 to 72 percent by weight, still more preferably 48.5 to 70 percent by weight, and especially preferably 51 to 70 percent by weight, based on the total amount of monomer components constituting the acrylic polymer (X) (100 percent by weight).
Though not especially limited, as long as being a monomer containing cyano group, examples of the cyano group-containing monomer (b) include acrylonitrile and methacrylonitrile. Among them, acrylonitrile is preferably used as the cyano group-containing monomer (b). Each of different cyano group-containing monomers (b) may be used alone or in combination.
In the present invention, the cyano group-containing monomer (b) is preferably used for further improving the thermal stability after exposure to heat and moist. For this purpose, the amount of the cyano group-containing monomer (b) is preferably 24 to 60 percent by weight, more preferably 25 to 55 percent by weight, still more preferably 25 to 50 percent by weight, and especially preferably 28 to 43 percent by weight, based on the total amount of monomer components constituting the acrylic polymer (X) (100 percent by weight). If the amount of the cyano group-containing monomer (b) is less than 24 percent by weight based on the total amount of monomer components, the thermosetting adhesive layer may have insufficient thermal stability after exposure to heat and moist; and in contrast, if it exceeds 60 percent by weight, the thermosetting adhesive layer may show insufficient flexibility.
Though not especially limited, as long as being a monomer containing one or more carboxyl groups, examples of the carboxyl group-containing monomer (c) include (meth)acrylic acid [acrylic acid and/or methacrylic acid], itaconic acid, maleic acid, fumaric acid, and crotonic acid. Exemplary carboxyl group-containing monomers (c) further include

acid anhydrides of these carboxyl group-containing monomers, such as maleic anhydride, itaconic anhydride, and other monomers containing acid anhydride group. Of such carboxyl group-containing monomers (c), acrylic acid, methacrylic acid, and itaconic acid are preferred. Each of different carboxyl group-containing monomers (c) may be used alone or in combination.

In the present invention, the carboxyl group-containing monomer (c) is preferably used for further improving the thermal stability after exposure to heat and moist and for further improving the adhesiveness. For this purpose, the amount of the carboxyl group-containing monomer (c) is preferably 0.5 to 10 percent by weight, more preferably 1 to 9 percent by weight, still more preferably 1.5 to 8 percent by weight, and especially preferably 1.5 to 6 percent by weight, based on the total amount of monomer components constituting the acrylic polymer (X) (100 percent by weight). If the amount of the carboxyl group-containing monomer (c) exceeds 10 percent by weight based on the total amount of monomer components, the thermosetting adhesive layer may have insufficient flexibility; and, in contrast, if it is less than 0.5 percent by weight, the carboxyl group-containing monomer (c) may not sufficiently exhibit its activities. When the thermosetting adhesive composition does not contain the after-mentioned acid (Z), the amount of the carboxyl group-containing monomer (c) is preferably 3 to 10 percent by weight, more preferably 3 to 9 percent by weight, and still more preferably 3 to 8 percent by weight, based on the total amount of monomer components, for further satisfactory thermal stability after exposure to heat and moist.

The monomer components for constituting the acrylic polymer (X) may further contain one or more other monomer components (copolymerizable monomers) in addition to the ($C_2$-$C_{14}$)-alkyl (meth)acrylate (a), cyano group-containing monomer (b), and carboxyl group-containing monomer (c). Exemplary copolymerizable monomers for use herein include methyl (meth)acrylates; alkyl (meth)acrylates whose alkyl moiety having 15 to 20 carbon atoms, such as pentadecyl (meth)acrylates, hexadecyl (meth)acrylates, heptadecyl (meth)acrylates, octadecyl (meth)acrylates, nonadecyl (meth)acrylates, and eicosyl (meth)acrylates; nonaromatic-ring-containing (meth)acrylates including cycloalkyl (meth)acrylates [e.g., cyclohexyl (meth)acrylates], and isobornyl (meth)acrylates; aromatic-ring-containing (meth)acrylates including aryl (meth)acrylates [e.g., phenyl (meth)acrylates], aryloxyalkyl (meth)acrylates [e.g., phenoxyethyl (meth)acrylates], and arylalkyl (meth)acrylates [e.g., benzyl (meth)acrylates]; epoxy-containing acrylic monomers such as glycidyl (meth)acrylates and methylglycidyl (meth)acrylates; vinyl ester monomers such as vinyl acetate and vinyl propionate; styrenic monomers such as styrene and $\alpha$-methylstyrene; hydroxyl-containing monomers such as hydroxyethyl (meth)acrylates, hydroxypropyl (meth)acrylates, and hydroxybutyl (meth)acrylates; alkoxyalkyl (meth)acrylate monomers such as methoxyethyl (meth)acrylates and ethoxyethyl (meth)acrylates; aminoalkyl (meth)acrylate monomers such as aminoethyl (meth)acrylates, N,N-dimethylaminoethyl (meth)acrylates, and t-butylaminoethyl (meth)acrylates; (N-substituted) amide monomers such as (meth)acrylamides, N,N-dimethyl(meth)acrylamides, N-butyl(meth)acrylamides, and N-hydroxy(meth)acrylamides; olefinic monomers such as ethylene, propylene, isoprene, and butadiene; and vinyl ether monomers such as methyl vinyl ether.

Examples of the copolymerizable monomers further include multifunctional monomers such as hexanediol di (meth)acrylates, (poly)ethylene glycol di(meth)acrylates, (poly)propylene glycol di(meth)acrylates, neopentyl glycol di (meth)acrylates, pentaerythritol di(meth)acrylates, glycerol di(meth)acrylates, trimethylolpropane tri(meth)acrylates, pentaerythritol tri(meth)acrylates, dipentaerythritol hexa(meth)acrylates, divinylbenzene, butyl di(meth)acrylates, and hexyl di(meth)acrylates.

The acrylic polymer (X) can be prepared by a known or common polymerization technique, such as solution polymerization, emulsion polymerization, suspension polymerization, bulk polymerization, or polymerization through ultraviolet ray irradiation.

One or more agents such as polymerization initiators, emulsifiers, and chain-transfer agents may be used in the polymerization of the acrylic polymer (X). Such agents are not especially limited and can be chosen as appropriate from among known or common agents. More specifically, exemplary polymerization initiators include azo polymerization initiators such as 2,2'-azobisisobutyronitrile, 2,2'-azobis(4-methoxy-2,4-dimethylvaleronitrile), 2,2'-azobis(2,4-dimethylvaleronitrile), 2,2'-azobis(2-methylbutyronitrile), 1,1'-azabis(cyclohexane-1-carbonitrile), 2,2'-azobis(2,4,4-trimethylpentane), dimethyl 2,2'-azobis(2-inethylpropionate), and 2,2'-azobis{2-[1-(2-hydroxyethyl)-2-imidazolin-2-yl]propane} dihydrochloride; and peroxide polymerization initiators such as benzoyl peroxide, t-butyl hydroperoxide, di-t-butyl peroxide, t-butyl peroxybenzoate, dicumyl peroxide, 1,1-bis(t-butylperoxy)-3,3,5-trimethylcyclohexane, and 1,1-bis(t-butylperoxy) cyclododecane. Each of different polymerization initiators can be used alone or in combination. The amount of polymerization initiators can be chosen as appropriate from commonly adopted ranges.

Exemplary chain-transfer agents include dodecanethiol, 2-mercaptoethanol, lauryl mercaptan, glycidyl mercaptan, mercaptoacetic acid, 2-ethylhexyl thioglycolate, 2,3-dimercapto-1-propanol, and $\alpha$-methylstyrene dimer. Exemplary emulsifiers include anionic emulsifiers such as sodium laurylsulfate, ammonium laurylsulfate, sodium dodecylbenzenesulfonate, sodium polyoxyethylene alkyl ether sulfates, ammonium polyoxyethylene alkyl phenyl ether sulfates, and sodium polyoxyethylene alkyl phenyl ether sulfates; and nonionic emulsifiers such as polyoxyethylene alkyl ethers and polyoxyethylene alkyl phenyl ethers.

Commonly used solvents can be used in the solution polymerization. Exemplary solvents herein include organic

solvents including esters such as ethyl acetate and n-butyl acetate; aromatic hydrocarbons such as toluene and benzene; aliphatic hydrocarbons such as n-hexane and n-heptane; alicyclic hydrocarbons such as cyclohexane and methylcyclohexane; and ketones such as methyl ethyl ketone and methyl isobutyl ketone. Each of different solvents can be used alone or in combination.

Though not critical, the weight-average molecular weight of the acrylic polymer (X) can be chosen as appropriate within ranges of, for example, $20x\ 10^4$ to $160x\ 10^4$, preferably $30x\ 10^4$ to $140x\ 10^4$, and more preferably $30x\ 10^4$ to $70x\ 10^4$. The weight-average molecular weight of the acrylic polymer (X) can be controlled typically by the types and amounts of polymerization initiators and chain-transfer agents, the temperature and time (duration) of polymerization, monomer concentrations, and dropping rate of monomers.

The weight-average molecular weight can be measured through gel permeation chromatography (GPC). More specifically, the weight-average molecular weight can be measured according to the following measuring method through GPC.

Preparation of Sample

The acrylic polymer (X) is dissolved in an eluent to give a 0.1% dimethylformamide (DMF) solution, the solution is left stand for one day, filtrated through a 0.45-μm membrane filter, and the filtrate is subjected to a GPC measurement.

Measuring Conditions

GPC apparatus: HLC-8120GPC (supplied by Tosoh Corporation)
Columns: TSKgel superAWM-H, TSKgel superAW4000, and TSKgel superAW2500 (each supplied by Tosoh Corporation)
Column size: each 6 mm in diameter and 15 cm in length, total 45 cm in length
Column temperature: 40°C
Eluent: 10 mM LiBr and 10 mM phosphoric acid in DMF
Flow rate: 0.4 mL/min
Inlet pressure: 4.6 MPa
Sample amount: 20 μL
Detector: differential refractive index detector Reference material: polyethylene oxide
Data processor: GPC-8020 (supplied by Tosoh Corporation)

Etherified Phenolic Resin (Y)

As used herein the "etherified phenolic resin (Y)" refers to a phenolic resin having methylol groups part of which are etherified.

The phenolic resin acting as a backbone of the etherified resin (Y) is not limited, and the etherified phenolic resin (Y) can be any one without limitation, as long as part of methylol groups of the phenol resin are etherified. The etherified phenolic resin (Y) can be chosen as appropriate typically from among etherified novolac type phenolic resins, etherified resol type phenolic resins, and etherified cresol resins. Among them, etherified cresol resins are preferred, of which butyl-etherified cresol resins (i.e., cresol resins part of whose methylol groups are etherified with butyl) are more preferred.

The proportion of etherified methylol groups in the etherified phenolic resin (Y) is preferably, for example, such that the amount of etherified methylol groups is 50 percent by mole or more per the total moles (100 percent by mole) of the etherified methylol groups and non-etherified methylol groups. If the proportion of the etherified methylol groups is less than 50 percent by mole, the phenolic resin may become more susceptible to a reaction at room temperature or may show insufficient reactivity during curing through heating.

The etherified phenolic resin (Y) is preferably an etherified phenolic resin represented by following Formula (4):

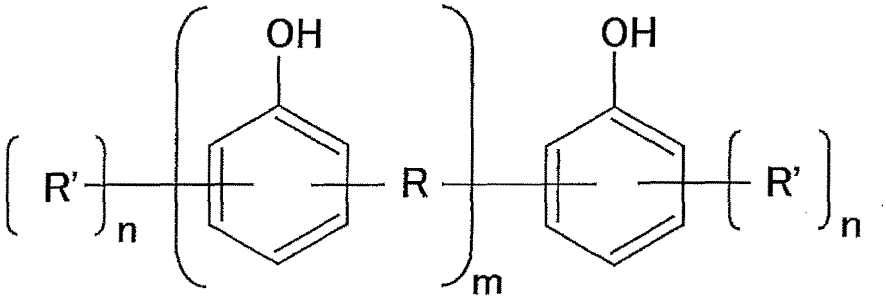

(4)

In Formula (4), R represents $-CH_2-$ or $-CH_2OCH_2-$; R' represents -H or $-CH_2OR''$ or $-CH_2OH$ when R' is in the ortho position or para position of hydroxyl group, and R' represents -H or $-CH_3$ when R' is in the meta position of hydroxyl group; and R" represents an alkyl group represented by: $-C_1H_{21+1}$.

In Formula (4), the repetition number "m" is not critical, as long as being a positive integer, and can be chosen within the range typically of 1 to 50. The repetition numbers "n"s are also not critical, as long as being positive integers, and can be chosen within the range typically of 1 to 4. The repetition numbers "n"s in Formula (4) may be numbers different from each other.

The alkyl group R" represented by $-C_1H_{21+1}$ in Formula (4) is not limited. The repetition number "1" is not critical, as long as being a positive integer, and can be chosen within the range typically of 1 to 20. Specifically, the alkyl group R" represented by $-C_1H_{21+1}$ can be chosen typically from among methyl group, ethyl group, propyl group, isopropyl group, n-butyl group, isobutyl group, s-butyl group, t-butyl group, pentyl group, isopentyl group, hexyl group, heptyl group, octyl group, 2-ethylhexyl group, isooctyl group, nonyl group, isononyl group, decyl group, isodecyl group, undecyl group, dodecyl group, tridecyl group, tetradecyl group, pentadecyl group, hexadecyl group, heptadecyl group, octadecyl group, nonadecyl group, and eicosyl group.

The etherified phenolic resin (Y) can be chosen from commercially available etherified phenolic resins, such as the trade name "SUMILITERESIN PR-55317" (supplied by Sumitomo Bakelite Co., Ltd., butyl etherified cresol resin, proportion of etherified methylol groups: 90 percent by mole), and the trade name "CSK-3898" (supplied by Showa Highpolymer Co., Ltd., butyl etherified cresol resin).

The etherified phenolic resin (Y) is used for imparting thermosetting properties and thermal stability after exposure to heat and moist. The amount of the etherified phenolic resin (Y) is preferably 1 to 40 parts by weight, more preferably 1 to 20 parts by weight, still more preferably 1 to 15 parts by weight, and especially preferably 1 to 10 parts by weight, per 100 parts by weight of the acrylic polymer (X). The etherified phenolic resin (Y), if in an amount of less than 1 part by weight per 100 parts by weight of the acrylic polymer (X), may fail to impart sufficient thermosetting properties. In contrast, the etherified phenolic resin (Y), if in an amount exceeding 40 parts by weight, may cause the adhesive to squeeze out upon pressing at high temperatures.

Acid (Z)

The acid (Z) is not limited, as long as being a proton donor, and can be chosen as appropriate typical from among organic acids and inorganic acids. Examples of the organic acids include tosyl acids such as p-toluenesulfonic acid; and carboxylic acids. Examples of the inorganic acids include phosphoric acid, hydrochloric acid, sulfuric acid, and nitric acid. The acid (Z) is preferably used herein, because the acid (Z) can help to accelerate the heat curing of the etherified phenolic resin (Y), thereby allows the curing reaction to proceed through heating at a lower temperature within a shorter time. This improves the productivity and allows the cured adhesive to have further excellent adhesive strength and thermal stability after exposure to heat and moist. The acid (Z) can be, for example, any of commercially available p-toluenesulfonic acids, hydrochloric acids, and phosphoric acids, such as products under the trade names "p-Toluenesulfonic Acid Monohydrate" (supplied by Tokyo Chemical Industry, Co., Ltd.), "10% Hydrochloric Acid" (supplied by Wako Pure Chemical Industries Ltd.), and "Phosphoric Acid" (supplied by Tokyo Chemical Industry, Co., Ltd.).

The acid (Z) is preferably used, because it accelerates the reaction (curing) of the etherified phenolic resin (Y). How the acid (Z) accelerates the reaction varies depending on the type and compounding ratio of the acid (Z). Regarding the type of the acid (Z), acids having an acid dissociation constant pKa of 10 or less are preferred, of which acids having a pKa of 5 or less are more preferred. An acid having a pKa of more than 10 may not sufficiently accelerate the reaction of the etherified phenolic resin.

The amount of the acid (Z) is preferably 0.01 to 1 part by weight, and more preferably 0.04 to 0.5 part by weight, per 100 parts by weight of the acrylic polymer (X). The acid (Z), if in an amount of less than 0.01 part by weight, may

fail to accelerate the reaction of the etherified phenolic resin (Y) sufficiently, and the resulting adhesive may show insufficient thermosetting properties and thermal stability after exposure to heat and moist. In contrast, the acid (Z), if in an amount exceeding 1 part by weight, may excessively accelerate the reaction of the etherified phenolic resin to thereby accelerate also the reaction at room temperature, and this may impair the storage stability.

The amount of p-toluenesulfonic acid (for example, the trade name "p-Toluenesulfonic Acid Monohydrate" (supplied by Tokyo Chemical Industry, Co., Ltd.)) (pKa of p-toluenesulfonic acid: -2.8), when used, is preferably 0.01 to 0.045 part by weight (in terms of p-toluenesulfonic acid) per 100 parts by weight of the acrylic polymer (X). p-Toluenesulfonic acid, if in an amount of less than 0.01 part by weight, may not sufficiently accelerate the reaction of the etherified phenolic resin (Y); and p-toluenesulfonic acid, if in an amount of more than 0.045 part by weight, may excessively accelerate the reaction of the etherified phenolic resin (Y) to thereby impede the thermosetting adhesive layer to have satisfactory storage stability.

The amount of hydrochloric acid (for example, the trade name "10% Hydrochloric Acid" (supplied by Wako Pure Chemical Industries Ltd.)) (pKa of hydrochloric acid: -4), when used, is preferably 0.05 to 0.5 part by weight (in terms of HCl) per 100 parts by weight of the acrylic polymer (X). Hydrochloric acid, if in an amount of less than 0.05 part by weight, may not sufficiently accelerate the reaction of the etherified phenolic resin (Y). In contrast, hydrochloric acid, if in an amount of more than 0.5 part by weight, may excessively accelerate the reaction of the etherified phenolic resin (Y) to thereby impede the thermosetting adhesive layer to have satisfactory storage stability.

The amount of phosphoric acid (for example, trade name "Phosphoric Acid" (supplied by Tokyo Chemical Industry, Co., Ltd.)) (pKa of phosphoric acid: 2.1), when used, is preferably 0.01 to 1 part by weight per 100 parts by weight of the acrylic polymer (X). Phosphoric acid, if in an amount of less than 0.01 part by weight, may not accelerate the reaction of the etherified phenolic resin (Y) sufficiently, and phosphoric acid, if in an amount of more than 1 part by weight, may excessively accelerate the reaction of the etherified phenolic resin (Y) to thereby impede the thermosetting adhesive layer to have satisfactory storage stability.

Where necessary, the thermosetting adhesive composition for constituting the thermosetting adhesive layer according to the present invention may further contain one or more known additives within ranges not adversely affecting features of the present invention, in addition to the acrylic polymer (X), etherified phenolic resin (Y), and acid (Z). Exemplary additives include age inhibitors, fillers, colorants (such as pigments and dyestuffs), ultraviolet absorbers, antioxidants, crosslinking agents, tackifiers, plasticizers, softeners, surfactants, and antistatic agents.

The thermosetting adhesive composition can be prepared, for example, by mixing the acrylic polymer (X) and etherified phenolic resin (Y), or, the acrylic polymer (X), etherified phenolic resin (Y), and acid (Z), and, where necessary, various additives (e.g., age inhibitors, fillers, and pigments).

The acrylic polymer (X) and the etherified phenolic resin (Y) can be used as a solution by dissolving in a solvent or used as a dispersion by dispersing in a disperse medium. Though not limited, the solvent and disperse medium can be chosen as appropriate typically from among the solvents exemplified above as solvents for use in the preparation of the acrylic polymer (X) through solution polymerization.

Thermosetting Adhesive Tapes or Sheets

The thermosetting adhesive tape or sheet according to the present invention may have a substrate or not, as long as having the thermosetting adhesive layer according to the present invention (thermosetting adhesive layer formed from the thermosetting adhesive composition). Exemplary thermosetting adhesive tapes or sheets herein therefore include (1) a thermosetting adhesive tape or sheet (a substrate-less thermosetting adhesive tape or sheet), which is composed of the thermosetting adhesive layer according to the present invention alone; and (2) a thermosetting adhesive tape or sheet (a substrate-supported thermosetting adhesive tape or sheet) which is composed of a substrate and, on or above at least one side (one side or both sides) thereof, the thermosetting adhesive layer according to the present invention. For easy and simple production, the thermosetting adhesive tape or sheet herein is preferably the thermosetting adhesive tape or sheet (1), i.e., the substrate-less thermosetting adhesive tape or sheet composed of the thermosetting adhesive layer according to the present invention alone. The term "substrate" does not include a release liner (separator) which is to be removed upon use of the thermosetting adhesive tape or sheet.

When the thermosetting adhesive tape or sheet is a substrate-supported thermosetting adhesive tape or sheet, the thermosetting adhesive layer according to the present invention has only to be present on or above at least one side of the substrate, and another layer may be present on or above the other side of the substrate. Such other layers include, for example, known pressure-sensitive adhesive layers and adhesive layers; and thermosetting adhesive layers other than the thermosetting adhesive layer according to the present invention.

The thermosetting adhesive tape or sheet may be wound as a roll or may be stacked as sheets. Specifically, the thermosetting adhesive tape or sheet according to the present invention can be in the form typically of sheet or tape. When the thermosetting adhesive tape or sheet is wound as a roll, the thermosetting adhesive layer in the roll may be protected typically by a release liner or a releasably treated layer arranged on the backside of the substrate.

The thickness of the thermosetting adhesive layer according to the present invention is, for example, preferably 5 to 100 μm, more preferably 10 to 50 μm, and especially preferably 20 to 40 μm. The thermosetting adhesive layer, if having a thickness exceeding 100 μm, may squeeze out during pressing at high temperatures. In contrast, the thermosetting adhesive layer, if having a thickness of less than 5 μm, may not show sufficient adhesiveness. The thermosetting adhesive layer may have a single-layer structure or multilayer structure.

The adhesive layer (thermosetting adhesive layer) in the thermosetting adhesive tape or sheet according to the present invention may be protected by a release liner (separator). The release liner herein is not especially limited and can be chosen as appropriate from among known release liners. Preferred exemplary release liners include release liners including a base such as paper or a plastic film, in which the surface of the base has been treated with a silicone; and release liners including a base such as paper or a plastic film, in which the surface of the base has been laminated with a polyolefin. Though not limited, the polyolefin is typically preferably a polyethylene and the like.

When the thermosetting adhesive tape or sheet according to the present invention has a substrate, examples of the substrate include, but are not limited to, appropriate thin articles including paper substrates such as papers; fibrous substrates such as fabrics, nonwoven fabric, and nets; metallic substrates such as metallic foils and metal sheets; plastic substrates including films and sheets made from various resins (e.g., olefinic resins, polyester resins, poly(vinyl chloride) resins, vinyl acetate resins, amide resins, polyimide resins, poly(ether ether ketone)s (PEEKs), and poly(phenylene sulfide)s (PPSs)); rubber substrates such as rubber sheets; foams such as sheet foams; and laminates of these articles (of which preferred are laminates of a plastic substrate with another substrate, and laminates of plastic films or sheets with each other).

Though not critical, the thickness of the substrate is preferably 10 to 500 μm, more preferably 12 to 200 μm, and still more preferably 15 to 100 μm. The substrate may have a single-layer structure or multilayer structure. Where necessary, the substrate may have undergone one or more treatments such as backing, antistatic treatment, and primer coating.

The thermosetting adhesive tape or sheet may have one or more other layers within ranges not adversely affecting the advantages of the present invention. Examples of such other layers include intermediate layers and under coats.

The thermosetting adhesive tape or sheet according to the present invention can be produced according to a common process for the production of pressure-sensitive adhesive tapes or sheets. Typically, the thermosetting adhesive tape or sheet, when being a substrate-less thermosetting adhesive tape or sheet, can be produced by applying a solution of the thermosetting adhesive composition to a release surface of a release liner to give a layer having a predetermined thickness after drying; and drying the applied layer.

A common coater can be used in the application of the solution of the thermosetting adhesive composition. Exemplary coaters include gravure roll coaters, reverse roll coaters, kiss roll coaters, dip roll coater, bar coaters, knife coaters, and spray roll coaters.

The thermosetting adhesive tape or sheet according to the present invention can exert a satisfactory adhesive strength through heating to proceed the curing reaction (i.e., by undergoing heat curing).

The thermosetting adhesive tape or sheet according to the present invention, when cured through heating, gives an adhesive tape or sheet (thermally-cured thermosetting adhesive tape or sheet) having a high adhesive strength. Though not limited, the curing is preferably performed by heating at a temperature of 100°C or higher (for example, 100°C to 200°C) for a duration of 30 minutes or more (for example, 30 to 360 minutes), and more preferably by heating at a temperature of 150°C or higher (for example, 150°C to 200°C) for a duration of 60 minutes or more (for example, 60 to 360 minutes).

The thermosetting adhesive tape or sheet according to the present invention can be stored at room temperature over a long time. When heated, the thermosetting adhesive tape or sheet can undergo a curing reaction rapidly and sufficiently, and, after curing, can exert excellent adhesiveness and high thermal stability after exposure to heat and moist. The thermosetting adhesive tape or sheet is therefore advantageously usable typically in applications where the adhesive tape or sheet should be stored at room temperature over a long time but, when heated, should be bonded firmly to an adherend with satisfactory thermal stability after exposure to heat and moist. Specifically, the thermosetting adhesive tape or sheet according to the present invention is advantageously usable in bonding in a flexible printed circuit board (FPC), i.e., it is advantageously usable as a thermosetting adhesive tape or sheet for FPC. The "bonding in a FPC" means that bonding during the preparation of the FPC or bonding between the FPC and a reinforcing sheet, as described above.

Most of FPCs pass through a high-temperature reflow process before being assembled into final products. Such a thermosetting adhesive tape or sheet to be used in FPCs is required to not suffer from problems such as lifting and blister after passing through the reflow process. Especially in application for FPC, the "thermal stability after exposure to heat and moist" is important in such thermosetting adhesive tape or sheet to be used in FPCs, from the viewpoint of reliability. The thermosetting adhesive tape or sheet according to the present invention can exert properties as a thermosetting adhesive in good balance and, after thermally cured, can exert satisfactory thermal stability after exposure to

heat and moist. The thermosetting adhesive tape or sheet according to the present invention can therefore be used as a thermosetting adhesive tape or sheet that has high reliability especially in FPCs.

A FPC including the thermosetting adhesive tape or sheet according to the present invention can be obtained by preparing a FPC using the thermosetting adhesive tape or sheet according to the present invention or by affixing a FPC with a reinforcing sheet through the thermosetting adhesive tape or sheet according to the present invention.

The FPC including the thermosetting adhesive tape or sheet according to the present invention can give a FPC having a thermosetting adhesive tape or sheet with a high adhesive strength (FPC having a thermally-cured thermosetting adhesive tape or sheet) by thermally curing the adhesive tape or sheet. Though not critical, the heat curing is preferably performed by heating at a temperature of 100°C or higher (for example, 100°C to 200°C) for a duration of 30 minutes or more (for example, 30 to 360 minutes), and more preferably by heating at a temperature of 150°C or higher (for example, 150°C to 200°C) for a duration of 60 minutes or more (for example, 60 to 360 minutes). Examples

The present invention will be illustrated in further detail with reference to several working examples below. It should be noted, however, that these examples are never construed to limit the scope of the present invention.

Example 1

In a reactor equipped with a condenser, a nitrogen inlet tube, a thermometer, and a stirrer were placed 0.279 g of 2,2'-azobis(2-[1-(2-hydroxyethyl)-2-imidazolin-2-yl]propane} dihydrochloride (trade name "VA-060", supplied by Wako Pure Chemical Industries Ltd.) (initiator) and 100 g of ion exchanged water, followed by stirring for 1 hour while introducing nitrogen gas. This mixture was held at 60°C, and 400 g of an emulsion of material monomers was gradually added dropwise thereto over 3 hours to proceed an emulsion polymerization reaction. The emulsion of material monomers had been prepared by adding 64 parts by weight of butyl acrylate (n-butyl acrylate) (BA), 34 parts by weight of acrylonitrile (AN), 2 parts by weight of acrylic acid (AA), 0.04 part by weight of dodecanethiol (chain-transfer agent), and 2 parts by weight of sodium polyoxyethylene lauryl ether sulfate (emulsifier) to 41 parts by weight of ion exchanged water to give an emulsion. After the completion of dropwise addition of the emulsion of material monomers, the mixture was aged by holding at the same temperature for 3 hours. The resulting aqueous dispersion (emulsion) of an acrylic polymer thus polymerized was dried to give an acrylic polymer (X1) having a weight-average molecular weight of $48 \times 10^4$.

The prepared acrylic polymer (X1) is a copolymer having a monomer composition of 64 parts by weight of butyl acrylate (BA), 34 parts by weight of acrylonitrile (AN), and 2 parts by weight of acrylic acid (AA). Next, a solution of thermosetting adhesive composition was prepared by mixing with stirring an ethyl acetate solution of 100 parts by weight of the acrylic polymer (X1) with a butanol solution of 10 parts by weight (in terms of non-volatile content) of the product under the trade name "SUMILITERESIN PR-55317" (supplied by Sumitomo Bakelite Co., Ltd.) as an etherified phenolic resin (Y1). Specifically, the solution of thermosetting adhesive composition contains 100 parts by weight of the acrylic polymer (X) and 10 parts by weight of the etherified phenolic resin (Y).

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 2

A solution of thermosetting adhesive composition was prepared by mixing with stirring an ethyl acetate solution of 100 parts by weight of the acrylic polymer (X1) [copolymer having a monomer composition of 64 parts by weight of butyl acrylate (BA), 34 parts by weight of acrylonitrile (AN), and 2 parts by weight of acrylic acid (AA)] with a butanol solution of 10 parts by weight (in terms of non-volatile content) of the product under the trade name "'SUMILITERESIN PR-55317" (supplied by Sumitomo Bakelite Co., Ltd.) as an etherified phenolic resin (Y1) and 0.2 part by weight of the product under the trade name "Phosphoric Acid" (supplied by Tokyo Chemical Industry, Co., Ltd.) as phosphoric acid. Specifically, the solution of thermosetting adhesive composition contains 100 parts by weight of the acrylic polymer (X), 10 parts by weight of the etherified phenolic resin (Y), and 0.2 part by weight of phosphoric acid.

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 3

A solution of thermosetting adhesive composition was prepared by mixing with stirring an ethyl acetate solution of 100 parts by weight of the acrylic polymer (X1) [copolymer having a monomer composition of 64 parts by weight of butyl acrylate (BA), 34 parts by weight of acrylonitrile (AN), and 2 parts by weight of acrylic acid (AA)] with a butanol solution of 10 parts by weight (in terms of non-volatile content) of the product under the trade name "SUMILITERESIN

PR-55317" (supplied by Sumitomo Bakelite Co., Ltd.) as an etherified phenolic resin (Y1) and 0.045 part by weight (in terms of p-toluenesulfonic acid) of the product under the trade name "p-Toluenesulfonic Acid Monohydrate" (supplied by Tokyo Chemical Industry, Co., Ltd.) as p-toluenesulfonic acid. Specifically, the solution of thermosetting adhesive composition contains 100 parts by weight of the acrylic polymer (X), 10 parts by weight of the etherified phenolic resin (Y), and 0.045 part by weight of p-toluenesulfonic acid.

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 4

A solution of thermosetting adhesive composition was prepared by mixing with stirring an ethyl acetate solution of 100 parts by weight of the acrylic polymer (X1) [copolymer having a monomer composition of 64 parts by weight of butyl acrylate (BA), 34 parts by weight of acrylonitrile (AN), and 2 parts by weight of acrylic acid (AA)] with a butanol solution of 10 parts by weight (in terms of non-volatile content) of the product under the trade name "SUMILITERESIN PR-55317" (supplied by Sumitomo Bakelite Co., Ltd.) as an etherified phenolic resin (Y1) and 0.1 part by weight (in terms of HCl) of the product under the trade name "10% Hydrochloric Acid" (supplied by Wako Pure Chemical Industries Ltd.) as hydrochloric acid. Specifically, the solution of thermosetting adhesive composition contains 100 parts by weight of the acrylic polymer (X), 10 parts by weight of the etherified phenolic resin (Y), and 0.1 part by weight of hydrochloric acid.

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 5

An acrylic polymer (X2) used herein was a copolymer having a monomer composition of 64 parts by weight of butyl acrylate (BA), 32 parts by weight of acrylonitrile (AN), and 4 parts by weight of acrylic acid (AA) and having a weight-average molecular weight of 52x $10^4$. A solution of thermosetting adhesive composition was prepared by mixing with stirring an ethyl acetate solution of 100 parts by weight of the acrylic polymer (X2) with a butanol solution of 10 parts by weight (in terms of non-volatile content) of the product under the trade name "SUMILITERESIN PR-55317" (supplied by Sumitomo Bakelite Co., Ltd.) as an etherified phenolic resin (Y1). Specifically, the solution of thermosetting adhesive composition contains 100 parts by weight of the acrylic polymer (X) and 10 parts by weight of the etherified phenolic resin (Y).

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 6

An acrylic polymer (X3) used herein was a copolymer having a monomer composition of 57 parts by weight of butyl acrylate (BA), 39 parts by weight of acrylonitrile (AN), and 4 parts by weight of acrylic acid (AA) and having a weight-average molecular weight of 37x $10^4$. A solution of thermosetting adhesive composition was prepared by mixing with stirring an ethyl acetate solution of 100 parts by weight of the acrylic polymer (X3) with a butanol solution of 10 parts by weight (in terms of non-volatile content) of the product under the trade name "SUMILITERESIN PR-55317" (supplied by Sumitomo Bakelite Co., Ltd.) as an etherified phenolic resin (Y1) Specifically, the solution of thermosetting adhesive composition contains 100 parts by weight of the acrylic polymer (X) and 10 parts by weight of the etherified phenolic resin (Y).

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 7

An acrylic polymer (X4) used herein was a copolymer having a monomer composition of 64 parts by weight of butyl acrylate (BA), 31 part by weight of acrylonitrile (AN), and 5 parts by weight of acrylic acid (AA) and having a weight-average molecular weight of 39x $10^4$. A solution of thermosetting adhesive composition was prepared by mixing with stirring an ethyl acetate solution of 100 parts by weight of the acrylic polymer (X4) with a butanol solution of 10 parts by weight (in terms of non-volatile content) of the product under the trade name "SUMILITERESIN PR-55317" (supplied

by Sumitomo Bakelite Co., Ltd.) as an etherified phenolic resin (Y1). Specifically, the solution of thermosetting adhesive composition contains 100 parts by weight of the acrylic polymer (X) and 10 parts by weight of the etherified phenolic resin (Y).

The solution of thermosetting adhesive composition was applied to a release surface of a release liner, dried at 100°C for 3 minutes so as to give a layer having a thickness after drying of 25 μm, and thereby yielded a thermosetting adhesive sheet.

Example 8

An acrylic polymer (X5) used herein was a copolymer having a monomer composition of 66 parts by weight of butyl acrylate (BA), 29 part by weight of acrylonitrile (AN), and 5 parts by weight of acrylic acid (AA) and having a weight-average molecular weight of 34x $10^4$. A solution of thermosetting adhesive composition was prepared by mixing with stirring an ethyl acetate solution of 100 parts by weight of the acrylic polymer (X5) with a butanol solution of 10 parts by weight (in terms of non-volatile content) of the product under the trade name "CKS-3898" (supplied by Showa Highpolymer Co., Ltd.) as an etherified phenolic resin (Y2). Specifically, the solution of thermosetting adhesive composition contains 100 parts by weight of the acrylic polymer (X) and 10 parts by weight of the etherified phenolic resin (Y).

The solution of thermosetting adhesive composition was applied to a release surface of a release liner, dried at 100°C for 3 minutes so as to give a layer having a thickness after drying of 35 μm, and thereby yielded a thermosetting adhesive sheet.

Example 9

An acrylic polymer (X5) used herein was a copolymer having a monomer composition of 66 parts by weight of butyl acrylate (BA), 29 part by weight of acrylonitrile (AN), and 5 parts by weight of acrylic acid (AA) and having a weight-average molecular weight of 34x $10^4$. A solution of thermosetting adhesive composition was prepared by mixing with stirring an ethyl acetate solution of 100 parts by weight of the acrylic polymer (X5) with a butanol solution of 12 parts by weight (in terms of non-volatile content) of the product under the trade name "CKS-3898"(supplied by Showa Highpolymer Co., Ltd.) as an etherified phenolic resin (Y2). Specifically, the solution of thermosetting adhesive composition contains 100 parts by weight of the acrylic polymer (X) and 12 parts by weight of the etherified phenolic resin (Y).

The solution of thermosetting adhesive composition was applied to a release surface of a release liner, dried at 100°C for 3 minutes so as to give a layer having a thickness after drying of 35 μm, and thereby yielded a thermosetting adhesive sheet.

Example 10

An acrylic polymer (X5) used herein was a copolymer having a monomer composition of 66 parts by weight of butyl acrylate (BA), 29 part by weight of acrylonitrile (AN), and 5 parts by weight of acrylic acid (AA) and having a weight-average molecular weight of 34x $10^4$. A solution of thermosetting adhesive composition was prepared by mixing with stirring an ethyl acetate solution of 100 parts by weight of the acrylic polymer (X5) with a butanol solution of 13 parts by weight (in terms of non-volatile content) of the product under the trade name "CKS-3898" (supplied by Showa Highpolymer Co., Ltd.) as an etherified phenolic resin (Y2). Specifically, the solution of thermosetting adhesive composition contains 100 parts by weight of the acrylic polymer (X) and 13 parts by weight of the etherified phenolic resin (Y).

The solution of thermosetting adhesive composition was applied to a release surface of a release liner, dried at 100°C for 3 minutes so as to give a layer having a thickness after drying of 35 μm, and thereby yielded a thermosetting adhesive sheet.

Comparative Example 1

The acrylic polymer (X1) used herein was a copolymer having a monomer composition of 64 parts by weight of butyl acrylate (BA), 34 parts by weight of acrylonitrile (AN), and 2 parts by weight of acrylic acid (AA). A solution of thermosetting adhesive composition was prepared by mixing with stirring an ethyl acetate solution of 100 parts by weight of the acrylic polymer (X1) with a methanol solution of 10 parts by weight (in terms of non-volatile content) of the product under the trade name "SUMILITERESIN PR-51283" (supplied by Sumitomo Bakelite Co., Ltd.), as a resol type phenolic resin whose methylol groups had not been etherified. Specifically, the solution of thermosetting adhesive composition contains 100 parts by weight of the acrylic polymer (X) and 10 parts by weight of the resol type phenolic resin.

The solution of thermosetting adhesive composition was applied to a release surface of a release liner, dried at 100°C for 3 minutes so as to give a layer having a thickness after drying of 25 μm, and thereby yielded a thermosetting adhesive sheet.

Comparative Example 2

The acrylic polymer (X2) used herein was a copolymer having a monomer composition of 64 parts by weight of butyl acrylate (BA), 32 parts by weight of acrylonitrile (AN), and 4 parts by weight of acrylic acid (AA). A solution of thermosetting adhesive composition was prepared by mixing with stirring an ethyl acetate solution of 100 parts by weight of the acrylic polymer (X2) with a methanol solution of 5 parts by weight (in terms of non-volatile content) of the product under the trade name "SUMILITERESIN PR-51283" (supplied by Sumitomo Bakelite Co., Ltd.) as a resol type phenolic resin whose methylol groups had not been etherified, and an ethyl acetate solution of 5 parts by weight of the product under the trade name "#1001" (supplied by Japan Epoxy Resins Co., Ltd.) as a (bisphenol-A) epoxy resin. Specifically, the solution of thermosetting adhesive composition contains 100 parts by weight of the acrylic polymer (X), 5 parts by weight of the resol type phenolic resin, and 5 parts by weight of the epoxy resin.
The solution of thermosetting adhesive composition was applied to a release surface of a release liner, dried at 100°C for 3 minutes so as to give a layer having a thickness after drying of 25 μm, and thereby yielded a thermosetting adhesive sheet.

Evaluations

The thermosetting adhesive sheets prepared according to the examples and comparative examples were subjected to measurements and evaluations of the adhesive strength and thermal stability after exposure to heat and moist of the cured thermosetting adhesive layer, the gel fraction, reactivity, and storage stability of the adhesive layer according to methods for measurement and methods for evaluation mentioned below. In Table 1 and Table 2, the amounts (parts by weight) of the etherified phenolic resin and resol type phenolic resin are amounts indicated in terms of non-volatile contents. The amounts (parts by weight) of p-toluenesulfonic acid and hydrochloric acid are amounts indicated in terms of p-toluenesulfonic acid and HCl, respectively.

(1) Method for Measuring Adhesive Strength

The adhesive strength (N/cm) at 23°C was evaluated according to the following method on cured thermosetting adhesive layers of the thermosetting adhesive sheets prepared according to the examples and comparative examples. Specifically, a sample thermosetting adhesive sheet was laminated with a flexible printed circuit board (FPC; having a size of 5 cm by 8 cm and a thickness of 0.2 mm) at 130°C and cut to a piece 1 cm wide, in which the thermosetting adhesive sheet was laminated on all over one surface of the FPC, which surface was made from a polyimide. The piece was applied and laminated onto a stainless steel sheet (SUS 304BA sheet) (SUS; having a size of 5 cm by 5 cm) at 130°C, and these were bonded through heating and compressing at 170°C and 2 MPa for 120 seconds, followed by curing (heat curing) at 150°C for 1 hour to give a series of specimens.
The specimens were subjected to the measurement of a 90-degree peel adhesive strength (tensile speed: 50 mm/minute, 23°C; N/cm) using an apparatus under the trade name "TCM-1kNB" (supplied by Minebea Co., Ltd.), in which the FPC side was pulled.
The measured or evaluated results are shown in "Adhesive strength (N/cm) SUS" in Table 1 and Table 2.
Independently, a 90-degree peel adhesive strength was measured by the above measurement procedure, except for using a polyimide sheet (PI: having a size of 5 cm by 5 cm and a thickness of 0.13 mm) instead of the stainless steel sheet. The evaluated results are shown in "Adhesive strength (N/cm) PI" in Table 1 and Table 2.

(2) Method for Evaluation of Thermal Stability After Exposure to Heat And Moist

The cured thermosetting adhesive layer was subjected to evaluation of thermal stability after exposure to heat and moist in each of the thermosetting adhesive sheets prepared according to the examples and comparative examples. A sample thermosetting adhesive sheet was laminated with a copper-clad laminated sheet (CCL; laminate of a polyimide and copper, having a size of 5 cm by 8 cm and a thickness of 45 μm) at 130°C, and cut to a piece 1 cm wide, in which the thermosetting adhesive sheet was laminated all over the polyimide surface of the CCL. The piece was applied and laminated at 130°C to a polyimide sheet (PI; having a size of 5 cm by 5 cm and a thickness of 0.13 mm), and they were bonded with each other through heating and compressing at 170°C and 2 MPa for 120 seconds, followed by curing (heat curing) at 150°C for 1 hour, to give a series of specimens.
The specimens were left stand under humidified conditions at a temperature of 60°C and relative humidity of 90% for 24 hours, heated in an infrared heating furnace (IR heating furnace) through a reflow process at a peak temperature of 270°C, and whether or not and how lifting/separation and/or blister occurred in the thermosetting adhesive layer of the thermosetting adhesive sheets was visually observed.
The thermal stability of the specimens after exposure to heat and moist was evaluated in the following manner. A

specimen in which neither lifting/separation nor blister was observed in the thermosetting adhesive layer was evaluated as having good thermal stability ("A"); a specimen in which a small quantity of lifting/separation was observed at an edge of the bonded portion was evaluated as having acceptable thermal stability ("B"); and a specimen in which lifting/separation and blister were observed all over the thermosetting adhesive layer was evaluated as having poor thermal stability ("C"). The measured or evaluated results are shown in "Thermal stability after exposure to heat and moist" in Table 1 and Table 2.

Reflow Process

A reflow device or apparatus used herein was an infrared heating furnace [far-infrared conveyer heating furnace with its combination of infrared heater and hot air (supplied by Noritake Co., Limited); with a maximum temperature or peak temperature set at 270°C]. In this process, a thermocouple was fixed to the specimen surface through a pressure-sensitive adhesive tape (heat-resistant pressure-sensitive adhesive tape including a polyimide film substrate), and the surface temperature of the specimen was continuously measured with a temperature sensor [KEYENCE NR-250 (supplied by Keyence Corporation)]. FIG. 1 shows an exemplary temperature profile as a heating treatment condition in the reflow process, with the ordinate being the temperature (°C) and the abscissa being the time (second). The reflow process was conducted for 360 seconds.

(3) Method for Measuring Gel Fraction of Adhesive Layer

The gel fractions of the thermosetting adhesive sheets (thermosetting adhesive layers) prepared according to the examples and comparative examples were measured by the "method for measuring gel fraction" mentioned above. The measured or evaluated results are shown in "Gel fraction of adhesive layer" in Table 1 and Table 2.

(4) Method for Evaluating Storage Stability

The differences in gel fraction between before and after storage at 40°C for 7 days of the thermosetting adhesive sheets prepared according to the examples and comparative examples were measured by the "method for measuring difference in gel fraction" mentioned above.
The measured or evaluated results are shown in "storage stability" in Table 1 and Table 2.

(5) Method for Evaluating Reactivity

The thermosetting adhesive sheets prepared according to the examples and comparative examples were cured by heating at 150°C for 1 hour to give thermally-cured thermosetting adhesive sheets (thermally-cured thermosetting adhesive layers), and the gel fractions of the thermally-cured thermosetting adhesive sheets were measured by the "method for measuring gel fraction after curing" mentioned above.
The measured or evaluated results are shown in "Reactivity" in Table 1 and Table 2.
TABLE 1

| | | | Ex.1 | Ex. 2 | Ex. 3 | Ex. 4 | Ex. 5 | Ex. 6 | Ex. 7 | Com. Ex. 1 | Com. Ex. 2 |
|---|---|---|---|---|---|---|---|---|---|---|---|
| Acrylic polymer (X) | Amount (part by weight) | | 100 | 100 | 100 | 100 | 100 | 100 | 100 | 100 | 100 |
| | Monomer composition (by weight) | BA | 64 | 64 | 64 | 64 | 64 | 57 | 64 | 64 | 64 |
| | | AN | 34 | 34 | 34 | 34 | 32 | 39 | 31 | 34 | 32 |
| | | AA | 2 | 2 | 2 | 2 | 4 | 4 | 5 | 2 | 4 |
| | Weight-average molecular weight | | $48x10^4$ | $48x10^4$ | $48x10^4$ | $48x10^4$ | $52x10^4$ | $37x10^4$ | $39x10^4$ | $48x10^4$ | $52x10^4$ |
| Etherified phenolic resin (Y1) | | Amount (part by weight) | 10 | 10 | 10 | 10 | 10 | 10 | 10 | - | - |
| Resol type phenolic resin | | Amount (part by weight) | - | - | - | - | - | - | - | 10 | 5 |
| Acid (Z) | Phosphoric acid | Amount (part by weight) | - | 0.2 | - | - | - | - | - | - | - |
| | p-Toluenesulfonic acid | Amount (part by weight) | - | - | 0.045 | - | - | - | - | - | - |
| | Hydrochloric acid | Amount (part by weight) | - | - | - | 0.1 | - | - | - | - | - |
| Epoxy resin (bisphenol-A) | | Amount (part by weight) | - | - | - | - | - | - | - | - | 5 |
| Adhesive strength (N/cm) | SUS | | 21.1 | 9.3 | 23.0 | 23.1 | 25.6 | 19.8 | 20.4 | 13.2 | 30.9 |
| | PI | | 11.8 | 11.9 | 12.3 | 10.5 | 20.0 | 26.8 | 21.6 | 11.1 | 22.0 |
| Thermal stability after exposure to heat and moist | | | B | A | A | A | A | A | A | C | A |
| Gel fraction (%) of adhesive layer | | | 2 | 0 | 1 | 3 | 1 | 1 | 0 | 4 | 7 |
| Storage stability (at 40°C for 7 days) as difference in gel fraction (%) | | | 3 | 0 | 0 | 0 | 10 | 5 | 2 | 2 | 46 |
| Reactivity (curing at 150°C for 1 hour) as gel fraction (%) after curing | | | 93 | 97 | 96 | 97 | 97 | 99 | 98 | 80 | 94 |

TABLE 2

| | | | Ex. 8 | Ex. 9 | Ex.10 |
|---|---|---|---|---|---|
| Acrylic polymer (X) | Amount (part by weight) | | 100 | 100 | 100 |
| | Monomer composition (by weight) | BA | 66 | 66 | 66 |
| | | AN | 29 | 29 | 29 |
| | | AA | 5 | 5 | 5 |
| | Weight-average molecular weight | | $34x10^4$ | $34x10^4$ | $34x10^4$ |
| Etherified phenolic resin (Y2) | Amount (part by weight) | | 10 | 12 | 13 |
| Adhesive strength (N/cm) | SUS | | 33.7 | 34.5 | 34.2 |
| | PI | | 29.0 | 23.1 | 18.5 |
| Thermal stability after exposure to heat and moist | | | A | A | A |
| Gel fraction (%) of adhesive layer | | | 1 | 1 | 1 |
| Storage stability (at 40°C for 7 days) as difference in gel fraction (%) | | | 4 | 3 | 2 |
| Reactivity (curing at 150°C for 1 hour) as gel fraction (%) after curing | | | 96 | 96 | 96 |

As is demonstrated by Table 1 and Table 2, the thermosetting adhesive sheets according to the present invention, when cured, excel in adhesiveness and thermal stability after exposure to heat and moist. The thermosetting adhesive sheets have differences in gel fraction between before and after storage at 40°C for 7 days of 15% or less, thereby have excellent storage stability, and can be stored at room temperature for at least 6 months. In contrast, the sample having an insufficient gel fraction after curing (Comparative Example 1), when cured, shows inferior thermal stability after exposure to heat and moist; and the sample having a large difference in gel fraction between before and after storage at 40°C for 7 days (Comparative Example 2) undergoes a reaction of the thermosetting resin in the tape even at room temperature and thereby shows inferior storage stability.

Industrial Applicability

The thermosetting adhesive tape or sheet according to the present invention is advantageously usable in bonding in a flexible printed circuit board (FPC) where the adhesive tape or sheet should be stored at room temperature over a long time but, when heated, should be bonded firmly to an adherend with satisfactory thermal stability after exposure to heat and moist.

## Claims

1. A thermosetting adhesive tape or sheet comprising a thermosetting adhesive layer,
the thermosetting adhesive layer having a gel fraction of less than 70%, a difference in gel fraction between before and after storage at 40°C for 7 days [(gel fraction after storage at 40°C for 7 days)-(gel fraction before storage at 40°C for 7 days)] of 15% or less, and a gel fraction after curing at 150°C for 1 hour of 90% or more.

2. The thermosetting adhesive tape or sheet according to claim 1, wherein the thermosetting adhesive layer is formed from a thermosetting adhesive composition comprising an acrylic polymer (X) as a main component.

3. The thermosetting adhesive tape or sheet according to claim 2, wherein the acrylic polymer (X) comprises a $(C_2\text{-}C_{14})$-alkyl (meth)acrylate (a) as an essential monomer component.

4. The thermosetting adhesive tape or sheet according to claim 3, wherein the acrylic polymer (X) further comprises a cyano group-containing monomer (b) and a carboxyl group-containing monomer (c) as monomer components.

5. The thermosetting adhesive tape or sheet according to any one of claims 1 to 4, wherein the thermosetting adhesive

layer is formed from a thermosetting adhesive composition comprising an acrylic polymer (X) and an etherified phenolic resin (Y).

**6.** The thermosetting adhesive tape or sheet according to claim 5, wherein the thermosetting adhesive composition further comprises an acid (Z).

**7.** A flexible printed circuit board comprising the thermosetting adhesive tape or sheet according to any one of claims 1 to 6.

**8.** A thermally-cured thermosetting adhesive tape or sheet as a thermally-cured product of the thermosetting adhesive tape or sheet according to any one of claims 1 to 6.

**9.** A flexible printed circuit board comprising the thermosetting adhesive tape or sheet according to claim 8.

**10.** The thermosetting adhesive tape or sheet according to any one of claims 1 to 6 and 8, as a thermosetting adhesive tape for a flexible printed circuit board.

Fig. 1

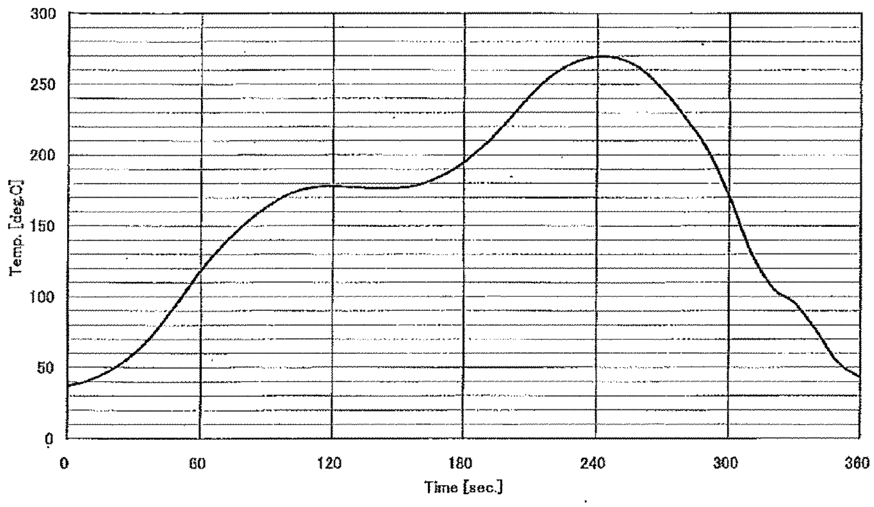
300
250
200
150
100
50
0
Temp. [deg.C]
0
60
120
180
240
300
360
Time [sec.]

**INTERNATIONAL SEARCH REPORT**

International application No.
PCT/JP2010/060670

A. CLASSIFICATION OF SUBJECT MATTER
*C09J7/00*(2006.01)i, *C09J11/06*(2006.01)i, *C09J133/20*(2006.01)i, *C09J161/06*(2006.01)i, *C09J201/00*(2006.01)i, *H05K1/03*(2006.01)i

According to International Patent Classification (IPC) or to both national classification and IPC

B. FIELDS SEARCHED

Minimum documentation searched (classification system followed by classification symbols)
C09J1/00-201/10, C08G4/00-16/06, H05K1/03

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-247910 A (Nitto Denko Corp.), 15 September 2005 (15.09.2005), claims 1 to 8; paragraphs [0045] to [0050] & US 2005/0196574 A1 & EP 1571191 A2 & DE 602005021175 D & CN 1664041 A & TW 277643 B & SG 114761 A | 1-10 |
| A | JP 2005-239830 A (Nitto Denko Corp.), 08 September 2005 (08.09.2005), claims 1 to 6; paragraphs [0029] to [0034] & US 2005/0187348 A1 & EP 1568748 A1 & DE 602005011693 D & KR 10-2006-0042166 A & CN 1660953 A | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>30 August, 2010 (30.08.10) | Date of mailing of the international search report<br>14 September, 2010 (14.09.10) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2010/060670

C (Continuation). DOCUMENTS CONSIDERED TO BE RELEVANT

| Category* | Citation of document, with indication, where appropriate, of the relevant passages | Relevant to claim No. |
|---|---|---|
| A | JP 2007-049036 A (Nitto Denko Corp.), 22 February 2007 (22.02.2007), claims 1 to 6; paragraphs [0032] to [0037] & US 2007/0036954 A1 & EP 1753277 A2 & CN 1913751 A | 1-10 |
| A | JP 05-171126 A (Sumitomo Chemical Co., Ltd.), 09 July 1993 (09.07.1993), claims 1 to 2; paragraphs [0010] to [0017] (Family: none) | 1-10 |
| A | JP 2006-265427 A (Sumitomo Bakelite Co., Ltd.), 05 October 2006 (05.10.2006), claims 1 to 7; paragraph [0005] (Family: none) | 1-10 |
| A | JP 2005-272710 A (Nitto Denko Corp.), 06 October 2005 (06.10.2005), claims 1 to 3; paragraphs [0020] to [0021] (Family: none) | 1-10 |
| A | JP 05-051569 A (Sekisui Chemical Co., Ltd.), 02 March 1993 (02.03.1993), claims 1 to 9; paragraph [0011] (Family: none) | 1-10 |
| A | JP 2005-139391 A (Shin-Etsu Chemical Co., Ltd.), 02 June 2005 (02.06.2005), claims 1 to 6; paragraphs [0017] to [0018] (Family: none) | 1-10 |
| A | JP 2002-275444 A (Hitachi Chemical Co., Ltd.), 25 September 2002 (25.09.2002), claims 1 to 17 & US 2003/0159773 A1 & WO 2001/074962 A1 & TW 245791 B | 1-10 |

Form PCT/ISA/210 (continuation of second sheet) (July 2009)

INTERNATIONAL SEARCH REPORT

International application No.
PCT/JP2010/060670

Claims 1-10

In claims 1-10, the inventions are specified by parameters "the gel fraction being less than 70%, the difference in gel fraction before and after storing at 40°C for 7 days [(gel fraction after storing at 40°C for 7 days)-(gel fraction before storing at 40°C for 7 days)] being 15% or less, and the gel fraction after curing at 150°C for 1 hour being 90% or more". However, the description discloses, in the meaning within PCT Article 5, nothing but a heat-curable adhesive tape or sheet provided with a heat-curable adhesive layer which contains a specific acrylic polymer and a specific etherified phenol resin at a specific mixing ratio. Therefore, claims 1-10 are not supported in the meaning within PCT Article 6.

The aforesaid parameters are not those which have been commonly used in the technical field. Even though the common technical knowledge at the point of the application is taken into consideration, therefore, it cannot be recognized that the scope of such a heat-curable adhesive tape or sheet that is specified by the aforesaid parameters could be specified. Thus, claims 1-10 do not comply with the requirement of clearness as defined in PCT Article 6.

Such being the case, the search was conducted, by referring to the heat-curable adhesive sheet provided with a heat-curable adhesive layer, which contains a specific acrylic polymer and a specific etherified phenol resin at a specific mixing ratio, that is specifically disclosed in the description, on a heat-curable adhesive sheet provided with a heat-curable adhesive layer which contains 100 parts by weight of an acrylic polymer comprising an alkyl (meth)acrylate having a linear or branched $C_{2-14}$ alkyl group, (meth)acrylonitrile and (meth)acrylic acid as copolymerizable components (copolymerization ratio: 39.5-75 wt%: 24-60 wt% : 0.5-10 wt%) and 1-40 parts by weight of an alkyl-etherified phenol resin.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005239830 A
- JP 2002275444 A